# EUROPÄISCHE PATENTSCHRIFT

(11) **EP 2 770 389 B1**
(45) Veröffentlichungstag und Bekanntmachung des Hinweises auf die Patenterteilung: **08.05.2019**
(21) Anmeldenummer: 13156323.1
(22) Anmeldetag: 22.02.2013
(51) Int. Cl.: G06F 11/22, G05B 23/02, G06F 17/50

(54) **Verfahren zur Durchführung einer Konfiguration eines Steuergeräte-Testsystems**
Method for performing a configuration of a control instrument test system
Procédé de réalisation d'une configuration d'un système de test d'appareils de commande

(30) Priorität: 21.02.2013 EP 13000867
(43) Veröffentlichungstag der Anmeldung: 27.08.2014
(73) Patentinhaber: dSPACE digital signal processing and control engineering GmbH, 33102 Paderborn (DE)
(72) Erfinder: Paule, Jürgen, 71157 Hildrizhausen (DE); Klahold, Jürgen, 33034 Brakel (DE)

(56) Entgegenhaltungen:
- EP-A1- 1 168 768
- EP-A1- 1 806 636
- JP-A- 2011 252 805

## Beschreibung

Die Erfindung betrifft ein Verfahren zur Durchführung einer Konfiguration eines Steuergeräte-Testsystems mit daran angeschlossenen Hardware-Komponenten, wobei mit dem Testsystem Steuergeräte in einer vom Testsystem mittels eines Modells simulierten Umgebung testbar sind und wobei das Testsystem zumindest einen Rechner, insbesondere einen das Modell ausführenden Rechner und Hardware-Komponenten umfasst, die mittels wenigstens eines Netzwerks miteinander verbunden sind.

Testsysteme zur Durchführung von Steuergerätetests sind im Stand der Technik bekannt. Getestet werden können beispielsweise Steuergeräte für Kraftfahrzeuge ebenso wie für andere Vorrichtungen, beispielsweise Fertigungsautomaten, wie Roboter oder auch andere Beförderungsmittel, wie beispielsweise Flugzeuge. Alle diese Vorrichtungen haben im Wesentlichen gemeinsam, dass diese wenigstens ein zu testendes Steuergerät aufweisen, welches Umweltdaten oder Daten von mit der Umwelt interagierenden Sensoren erfasst und hierauf reagiert.

Um die (einwandfreie) Funktion von Steuergeräten zu überprüfen, wird auf ein Verfahren zurückgegriffen, welches auch als "Hardware-in-the-loop" bezeichnet wird und welches im Wesentlichen besagt, dass ein konkret real existierendes elektronisches Steuergerät getestet wird, wofür dieses Steuergerät in ein Testsystem integriert wird, welches wenigstens einen Rechner umfasst, der eine Testumgebung simuliert, beispielsweise anhand eines darin gespeicherten und ausgeführten Modells sowie auch weiterhin Hardwarekomponenten umfasst, die miteinander zum Zweck der Kommunikation verbunden sind, was beispielsweise über wenigstens ein Netzwerk, insbesondere ein als Bus ausgebildetes Netzwerk erfolgen kann.

Typische Hardwarekomponenten, zu denen auch das zu testende Steuergerät selbst gehört, können beispielsweise Kabelbäume sein, mechatronische Komponenten, Echtlasten sowie sonstige Elektroniken, die zur Durchführung eines individuellen Tests benötigt werden, z.B. A/D-Wandler, Schnittstellen etc.

Insbesondere durch Echtlasten kann berücksichtigt werden, dass bei einem durchzuführenden Test gegebenenfalls bestimmte Umweltbedingungen, wie äußere Einflüsse auf ein Steuergerät nicht durch ein Modell in einer Simulation bereitgestellt werden, so dass in einem solchen Fall tatsächliche reale Lasten, zum Beispiel Aktoren, Sensoren oder sonstige Datengeber, insbesondere konkrete Hardwarekomponenten eines Systems, in welches ein Steuergerät bei seiner späteren Funktion eingebunden ist, an das Testsystem angeschlossen werden.

Ein konkretes Beispiel aus dem Kraftfahrzeugbereich ist die Anbindung einer Drosselklappe an das Testsystem, da diese ein simulativ nur schwer bis gar nicht erfassbares Verhalten aufweist. Ebenso können andere Echtlasten, wie z.B. ein Lenksystem oder ein Gas-, Brems- oder Kupplungspedal angeschlossen werden, auch wenn diese grundsätzlich simulierbar sind.

Ein konkreter Test kann beispielsweise vorsehen, dass die Eingänge eines Steuergerätes mit Sensordaten aus einem Modell stimuliert werden oder alternativ, sofern solche Sensordaten nicht aus einem Modell durch Simulation erhalten werden können, durch Daten aus den eingangs genannten realen Komponenten stimuliert werden.

Die Reaktion eines zu testenden Steuergerätes auf solche Daten kann durch das Rücklesen von Ausgangsdaten des Steuergerätes in das Modell beziehungsweise den das Modell ausführenden Rechner erfolgen und somit überprüft, also getestet werden. Vorteilhaft ist es, dass ein solches Testsystem im Wesentlichen in Echtzeit dem zu testenden Steuergerät eine Umgebung simulieren kann, so dass das Steuergerät getestet werden kann, als wäre es tatsächlich in derjenigen Vorrichtung verbaut, in der es später zum Einsatz kommen soll. Um Echtzeitfähigkeit zu ermöglichen, können Simulationszyklen eine bevorzugte Dauer von weniger als 1 ms aufweisen.

Eventuelle Fehler eines Steuergerätes können mittels eines solchen Testsystems frühzeitig erkannt, insbesondere durch wiederkehrende Simulationsabläufe reproduziert werden und die Beseitigung von aufgefundenen Fehlern, insbesondere durch Wiederholung der Testabläufe, die zum Fehler geführt haben, verifiziert werden.

Für die einwandfreie Funktion eines Testsystems ist es wesentlich, dass auch die Konfiguration des Testsystems korrekt durchgeführt wurde. Eine solche Konfiguration, das heißt die Zusammenstellung der einzelnen Hardware-Komponenten des Testsystems und die Berücksichtigung solcher Hardware-Komponenten in einem auszuführenden Modell, wird im Wesentlichen von Menschenhand durchgeführt, so dass sich eine Fehleranfälligkeit des Testsystems, insbesondere das darin ausgeführten Modells, auch dadurch ergibt, dass bei der Konfiguration falsche Hardwarekomponenten zu einem programmierten Modell verwendet werden oder ein falsches Modell oder zumindest falsch konfiguriertes oder parametriertes Modell für die gegebenen Hardware-Komponenten zusammengestellt, bzw. programmiert wurde.

Soll beispielsweise ein bestimmter Test, das heißt eine bestimmte Umweltbedingung oder Interaktion eines Steuergerätes mit der simulierten Umwelt, getestet werden, so kann ein Fehler schon dadurch erzeugt werden, dass ein Modell bei der Simulation verwendet wird, welches Daten erwartet, die von den Hardware-Komponenten nicht bereit gestellt werden oder welches diese Daten in einer für die betreffenden Hardwarekomponenten nicht geeigneten Weise verarbeitet.

Soll beispielsweise mittels eines Testsystems eine in einem Steuergerät implementierte Drosselklappensteuerung eines 6-Zylinder-Motors überprüft werden, so kann dieser Test ersichtlich nicht korrekt durchgeführt werden, wenn eine Konfigurierung bzw. Parametrierung des verwendeten Modells für eine 4-Zylinder-Drosselklappe erfolgt.

Die Fehleranfälligkeit eines von Hand konfigurierten Testsystems, insbesondere die Konfiguration oder Parametrierung des Modells kann beispielsweise reduziert werden, wenn eine Möglichkeit geschaffen wird, die technischen Anforderungen, die eine Hardware-Komponente an das Testsystem und hier insbesondere an das auszuführende Modell stellt, automatisiert dem Testsystem mitzuteilen.

Die Aufgabe der Erfindung ist es, ein Verfahren zur Konfiguration eines Steuergeräte-Testsystems, und hier insbesondere das darin ausgeführen Modells, bereit zu stellen, das im Wesentlichen menschliche Einflüsse als Fehlerquelle ausschließt und die Konfiguration automatisiert, insbesondere zur Erzielung einer größeren Prozesssicherheit.

Bevorzugt soll ein Verfahren bereitgestellt werden, das automatisch eine Konfiguration erstellt oder zumindest zu dieser beiträgt. So soll bevorzugt auch sichergestellt werden, dass bei einem Test auftretende Fehler auf eine Fehlfunktion im Steuergerät zurückzuführen sind, nicht jedoch auf einen Fehler im Testsystem, insbesondere bei der Konfiguration des Modells selbst.

Als Modell wird hier beispielsweise eine Software verstanden, die durch den Rechner eines Testsystems ausgeführt wird und mit den einzelnen an das Testsystem angeschlossenen Hardwarekomponenten kommuniziert zum Zweck des Datenaustausches im Rahmen der Simulation einer Umweltbedingung oderumgebung.

Das im Stand der Technik verankerte Problem der fehlerhaften technischen Konfiguration des Modells eines Testsystems oder auch von dessen Hardware-Komponenten, kann erfindungsgemäß dadurch gelöst werden, dass zumindest ein Teil der Hardware-Komponenten einen eigenen Server umfasst, der durch Kommunikation Zugang gewährt zu der Hardware-Komponente zugeordneten, insbesondere in der Hardware-Komponente gespeicherten Konfigurationsdaten und das Modell und/oder die Hardware-Komponente in Abhängigkeit der zugänglich gemachten Konfigurationsdaten angepasst, insbesondere konfiguriert wird.

Der wesentliche Kerngedanke des Verfahrens beruht demnach darauf, dass erfindungsgemäß zumindest ein Teil der an ein Testsystem angeschlossenen Hardwarekomponenten, bevorzugt alle Hardware-Komponenten selbst, die Konfigurationsdaten trägt bzw. mit sich führt, die in dem Testsystem, insbesondere ein dem Modell des Testsystems zur Durchführung von Test in Verbindung mit dieser Hardware-Komponente benötigt werden. Hierbei werden diese benötigten bzw. exakt zu der betreffenden Hardware-Komponente passenden Konfigurationsdaten mittels eines Servers zugänglich gemacht, der auf bzw. in dieser Hardware-Komponente abläuft.

Dabei wird unter einem Server eine Software bzw. ein Programm verstanden, das mit einem anderen Programm - auch als Client bezeichneten Programm - kommuniziert, um diesem anderen Programm Zugang zu speziellen Daten oder Diensten zu verschaffen.

Dabei kann es bevorzugt vorgesehen sein, dass zumindest alle solche Hardware-Komponenten mit einem Server versehen sind oder versehen werden, die als simulationsindividuell anzusehen sind, das heißt deren nicht korrekte individuelle Berücksichtigung im Modell des Testsystems sich auf das Simulationsergebnis beziehungsweise die Korrektheit des Testergebnisses unmittelbar auswirkt.

So kann es demnach in einem Testsystem zur Durchführung von Tests bei Steuergeräten durchaus Hardwarekomponenten geben, die allgemein für jegliche Art von Simulation und Tests an Steuergeräten eingesetzt werden können, die demnach also nicht simulationsindividuell sind, so dass solche Hardwarekomponenten generell innerhalb eines Testsystems unabhängig von der durchzuführenden Simulation bzw. dem Modell korrekt funktionsfähig sind, somit also ein Modell keiner individuellen Anpassung bzw. Konfiguration bedarf.

Bei solchen Hardwarekomponenten kann demnach keine Falschkonfiguration des Modells beziehungsweise kein fehlerhaftes Einbinden in ein Testsystem stattfinden, so dass es gegebenenfalls vorgesehen sein kann, solche Hardwarekomponenten ohne Server-Funktion in dem Testsystem zu verwenden.

Bevorzugt werden zumindest Hardwarekomponenten mit Servern ausgestattet, die für eine jeweils durchzuführende Simulation eine spezielle Anpassung bzw. Konfiguration des Modells oder auch von sich selbst benötigen. Ein Beispiel bildet die bereits eingangs genannte 6-Zylinder-Drosselklappe, die eine als Echtlast zu bezeichnende Hardwarekomponente darstellt, und die in einem nur für eine 4-Zylinder-Drosselklappe programmierten Modell zu einer Fehlfunktion führen würde, die sodann aber auf einer fehlerhafte Modellprogrammierung zurückzuführen wäre, nicht jedoch auf ein fehlerhaftes Steuergerät.

In diesem Beispiel kommt es somit darauf an, im Testsystem eine korrekte Paarung aus Steuergerät, Echtlast und dem Modell, welches die Daten aus diesen verarbeitet, zu erzielen.

Erfindungsgemäß kann es vorgesehen sein, dass im Rahmen der Zugangsgewährung durch Kommunikation mit dem Server ein Auslesen von solchen Konfigurationsdaten aus der Hardwarekomponente erfolgt, die bei der Ausführung des Modells oder bei der Kommunikation der Hardwarekomponente während einer Simulation benötigt werden. Die Konfigurationsdaten können somit verwendet werden um z.B. das Modell des Testsystems anzupassen bzw. zu ändern, welches auf dem Rechner des Testsystems ausgeführt wird. Alternativ oder zusätzlich können die Konfigurationsdaten auch verwendet werden, um die betreffende Hardwarekomponente, die den Server umfasst, zu konfigurieren.

Hierbei kann es erfindungsgemäß auch vorgesehen sein, dass das jeweilige Auslesen der Konfigurationsdaten aus den einzelnen Hardwarekomponenten, insbesondere den simulationsindividuellen Hardwarekomponenten mittels desjenigen Rechners des Testsystems erfolgt, welcher auch die eigentliche Simulation anhand des Modells, dass heißt eines im Wesentlichen auf dem Rechner vorhandenen durchzuführenden Simulationsalgorithmus durchführt.

Alternativ besteht auch die Möglichkeit, die einzelnen Konfigurationsdaten von den jeweiligen Hardwarekomponenten mittels eines an das Testsystem angeschlossenen Steuerrechners zu lesen, beispielsweise eines solchen Steuerrechners, mittels welchem auch im übrigen eine softwareseitige Konfiguration des Testsystems erfolgt.

Beispielsweise kann mittels eines solchen Steuerrechners auf den Rechner des Testsystems das Modell, das heißt die eine bestimmte Umweltbedingung simulierende Software übertragen werden und/oder mit zur Simulation benötigten Parametern versehen werden. Ebenso besteht die Möglichkeit mittels eines solchen Steuer-PCs Ergebnisse aus dem Testsystem auszulesen und gegebenenfalls zu visualisieren, insbesondere zur Überprüfung der Testsysteme durch Benutzer.

Unabhängig davon, welcher dieser Rechner Verwendung findet kann das Auslesen bedingen, dass ein Client-Prozess ausgeführt auf dem betreffenden Rechner, der mit dem Server der Hardware-Komponente kommuniziert, um über diesen Server den Zugang zu den Konfigurationsdaten zu erhalten.

Bei einem Auslesen mittels eines an das Testsystem angeschlossenen Steuer-Rechners kann sodann dieser Steuerrechner anhand aller von mehreren Hardware-Komponenten erhaltener Konfigurationsdaten die Konfiguration des auf dem Rechner des Testsystems laufenden Modells vornehmen bzw. auch die Konfiguration der einzelnen Hardware-Komponenten durchführen.

Typische Konfigurationsdaten können z.B. gebildet werden durch eine durch den Rechner des Testsystems ausführbare Modellkomponente, insbesondere Simulink-Komponente. Konfigurationsdaten können somit selbst auch eine Software darstellen, die zum Ablauf auf dem Testsystem bei der Verwendung dieser speziellen Hardware-Komponente, von der die Konfigurationsdaten stammen, benötigt wird.

Alternativ oder zusätzlich können Konfigurationsdaten auch beispielsweise Parameter oder Kennlinien eines Modells oder einer Modellkomponente umfassen oder auch eine die Hardware-Komponente beschreibende Information.

Neben der erfindungswesentlichen Möglichkeit Konfigurationsdaten zum Zweck der Anpassung des Testsystems, insbesondere des Modells oder der Hardware-Komponenten durch die Hardware-Komponenten selbst zu liefern, kann eine Weiterbildung auch zusätzlich vorsehen, dass ein Server einer Hardware-Komponente auch Zugang gewährt zu einer die Hardware-Komponente identifizierenden Information, insbesondere zu einer Seriennummer, insbesondere zur Durchführung einer Inventarisierung der Hardware-Komponenten des Testsystems. Eine solche Inventarisierung, d.h. z.B. eine gespeicherte, identifizierende Komponenteninformationen wiedergebende Liste kann beispielsweise mittels des genannten Steuerrechners visualisiert werden.

Eine erste mögliche vorteilhafte weitere Ausführung des erfindungsgemäßen Verfahrens kann es vorsehen, dass der Server einer Hardware-Komponente implementiert ist durch eine Software, die durch einen für die Funktion der Hardware-Komponente während eines Tests verwendeten Prozessor ausgeführt wird. Der Prozessor arbeitet somit sowohl während einer Simulation zum Zweck der Simulation, insbesondere derart, dass ohne diesen Prozessor die Simulation nicht möglich ist, als auch für die hier erfindungsgemäß durchgeführte Konfiguration. Dies ist beispielsweise der Fall bei einem Prozessor, auf welchem während der Durchführung eines Tests Prozessschritte durchgeführt werden.

Eine andere Ausführung, die auch mit der vorherigen kombinierbar ist, kann vorsehen, dass der Server implementiert ist durch eine Software, die auf einem für die Funktion der Hardware-Komponente während eines Tests nicht benötigten Server-Hardware, insbesondere die einen Prozessor umfasst, ausgeführt wird, welche zum Zweck der Bereitstellung des Servers an der Hardware-Komponente angeordnet wird.

Eine solche Server-Hardware kann in einer möglichen Ausführungsform keine andere Funktion aufweisen, als das Bereitstellen des Servers und ansonsten zumindest für die Durchführung eines Tests im Rahmen einer Simulation keine weitere Funktion haben, also am Test selbst nicht teilnehmen.

Bei dieser Ausführung erschließt es sich als vorteilhaft, dass Hardwarekomponenten, die ggfs. keinen Prozessor aufweisen, für den Zweck des erfindungsgemäßen Verfahrens extra ausgerüstet werden können, zum Beispiel durch Anbringung einer zusätzlichen Server-Hardware an der Hardwarekomponente, um sodann die Konfigurationsdaten über den so realisierten Server auszulesen und im Rahmen der Anpassung des Testsystems zu verwenden.

Eine weitere Ausführung des erfindungsgemäßen Verfahrens kann es hier auch vorsehen, dass bei Verwendung einer Hardwarekomponente, die entweder keinen Prozessor aufweist oder nicht nachträglich mit einer Server-Hardware ausgestattet werden kann, eine den Server dieser Hardwarekomponente ausführende Server-Hardware integriert wird in einem zur Verbindung dieser Hardwarekomponente mit dem Testsystem vorgesehenen Verbindungselement, insbesondere in einem Anschlußstecker eines solchen Verbindungselementes, wie z.B. eines Kabelbaumes, insbesondere wobei eine Aktivierung der Funktion des Servers erst durch eine Verbindung zwischen dieser Hardware-Komponente und dem Verbindungselement erfolgt. Bei einer solchen Hardwarekomponente kann es sich z.B. um ein Steuergerät handeln.

Beispielsweise können die betreffende Hardwarekomponente und das Verbindungselement zu einer neuen Einheit verbunden werden, insbesondere zu einer solchen Einheit, die nicht ohne Zerstörung trennbar ist.

Dies kann beispielsweise durch Verschrauben, Versiegeln oder Verplomben der Verbindung erfolgen.

Bei der Durchführung des erfindungsgemäßen Verfahrens kann es weiterhin vorgesehen sein, dass die Konfigurationsdaten über dasselbe Netzwerk zwischen Server und dem beteiligten Rechner kommuniziert werden, mittels dem die Hardwarekomponente während der Simulation mit dem das Modell ausführenden Rechner kommuniziert.

Es kann auch vorgesehen sein, dass ein Teil von Hardwarekomponenten des Testsystems mittels eines ersten Netzwerkes, beispielsweise mit einem ersten Bus an den Rechner des Testsystems angeschlossen ist und ein (anderer) Teil von Hardwarekomponenten des Testsystems, wie beispielsweise ein zu testendes Steuergerät und/oder Echtlasten mittels eines zweiten Netzwerkes, beispielsweise mit einem zweiten Bus an den Rechner des Testsystems angeschlossen ist, wobei die beiden Netzwerke, insbesondere die verwendeten Busse mittels eines Gateways verbunden sind, so dass sich hierdurch die Möglichkeit erschließt, Signale oder Daten auf einem der beiden Netzwerke auf das jeweils andere Netzwerk beziehungsweise den anderen Bus zu übertragen, insbesondere wobei ein solches Gateway beispielsweise eine Protokolltransformation vornehmen kann, sofern die beiden Netzwerke beziehungsweise Busse mit einem unterschiedlichen Kommunikationsprotokoll arbeiten.

Beispielsweise kann es hier vorgesehen sein, dass als erstes Netzwerk ein solches Netzwerk benutzt wird, welches proprietär von einem Hersteller zumindest des Rechners des Testsystems gegebenenfalls auch für das Testsystem vorgesehener, zwingender, insbesondere nicht simulationsindividueller Komponenten verwendet wird, wohingegen als zweites Netzwerk ein gegebenenfalls standardisiertes Netzwerk verwendet werden kann, um über ein solches Netzwerk oder einen standardisierten Bus weitere, insbesondere externe Komponenten, wie die eingangs genannten Steuergeräte oder externe (Echt-) Lasten, an den Rechner des Testsystemes anzuschließen.

Ein Beispiel für ein erstes Netzwerk kann das Netzwerk beziehungsweise der Bus IOCNET der Anmelderin dieser Erfindung eingesetzt werden, wobei als zweites Netzwerk der zum Beispiel in der Automobilindustrie etablierte CAN-Bus Verwendung finden kann. Es ist darauf hinzuweisen, dass die hier beschriebene Erfindung nicht auf die hier konkret benannten Netzwerke beziehungsweise Busse beschränkt ist, sondern selbstverständlich auch andere Netzwerke beziehungsweise Busse Verwendung finden können.

Durch die beschriebene Verwendung eines Gateways zur Verbindung der wenigstens zwei Netzwerke kann so sichergestellt werden, dass auch Konfigurationsdaten von an das zweite Netzwerk angeschlossenen Hardwarekomponenten unmittelbar über das zweite Netzwerk ausgelesen werden von einer jeweiligen Hardwarekomponente und beispielsweise über das Gateway, insbesondere ein erstes Gateway auf das erste Netzwerk übertragen werden, insbesondere in welchem der Rechner des Testsystems angeordnet ist, so dass die Konfigurationsdaten zumindest diesem Rechner zum Zwecke der Anpassung des Testsystems zur Verfügung steht, beziehungsweise über dieses Netzwerk auch an einen an das Testsystem angeschlossenen Steuerrechner übermittelt werden können zu demselben Zweck. Dies setzt voraus, dass ein Prozessor bzw. eine Server-Hardware, sei die originär vorhanden oder nachgerüstet, an wenigstens eines der wenigstens zwei genannten Netzwerke (Busse) angeschlossen ist.

Ist hingegen ein Server einer Hardwarekomponente, die im Testsystem eingebunden ist, weder über das eingangs genannte erste Netzwerk noch über das eingangs genannte zweite Netzwerk ansprechbar, was beispielsweise der Fall sein kann, wenn es sich um solche Hardwarekomponenten handelt, an denen zum Zweck der Bereitstellung eines Servers eine Server-Hardware ohne Bedeutung für die Funktion der Hardwarekomponente während eines Tests angeordnet ist, so kann es hier auch vorgesehen sein, die jeweiligem Konfigurationsdaten über ein Netzwerk zwischen Server und beteiligtem Rechner zu kommunizieren, welches zu demjenigen Netzwerk getrennt ist, mittels dem die Hardwarekomponente während der Simulation mit dem das Modell ausführenden Rechner kommuniziert. Zumindest der beteiligte Rechner ist sodann in wenigstens zwei getrennte Netzwerke eingebunden, eines für die Server-Kommunikation und eines für die Kommunikation bei einer Simulation.

Ein solches getrenntes Netzwerk für die Server-Kommunikation kann in einfachem Fall ein Ethernet sein.

Vorteilhaft ist die Ausführung mittels eines solchen getrennten Netzwerkes, da das Durchführen der erfindungsgemäßen Kommunikation zwischen Server und Rechner selbst dann eine Simulation, das heißt einen Test eines Steuergerätes nicht stört, sofern eine Übertragung von Konfigurationsdaten während der Laufzeit eines Tests vorgenommen wird.

Echtzeitanforderungen an das Testsystem können somit problemlos während der Durchführung eines Tests fortwährend aufrechterhalten werden, ohne eine Beeinflussung durch die erfindungsgemäße Serverkommunikation befürchten zu müssen.

Erfindungsgemäß kann es auch vorgesehen sein, dass ein Server Zugang gewährt zu zumindest einem Speicherplatz mit öffentlichen Daten und/oder zu zumindest einem Speicherplatz mit nicht-öffentlichen Daten, insbesondere nachdem der Server eine Authentifizierung eines anfragenden Rechners vorgenommen hat.

Ein Speicherplatz kann unabhängig von einer evtl. Zugriffsbeschränkung z.B. durch einen Flash-Speicher ausgebildet sein, der auf der Hardwarekomponente bereits für die ordnungsgemäße Funktion während eines Tests vorgesehen ist oder auch der auf einer separaten Server-Hardware angeordnet ist.

Eine bevorzugte Weiterbildung kann auch vorsehen, dass in der separaten Serverhardware mehrerer Hardware-Komponenten oder direkt in mehreren Hardwarekomponenten des Testsystems jeweils ein Client, insbesondere ein als Software ausgebildeter Client implementiert ist, wobei mittels des jeweiligen Client mehrere Server verschiedener Hardware-Komponenten miteinander vernetzt werden, die Konfigurationsdaten untereinander kommunizieren, insbesondere wobei ein beteiligter Rechner durch Kommunikation mit nur einem der vernetzten Server Zugang erhält zu den Konfigurationsdaten der mit diesem Server vernetzten anderen Server.

Weiterhin kann ein Server eine Web-Server-Funktionalität umfassen, mittels der, insbesondere unter Verwendung des Steuer-Rechners, Änderungen an den durch den Server zugänglich gemachten Daten vorgenommen werden können.

Ausführungsbeispiele der Erfindung werden im Nachfolgenden beschrieben.

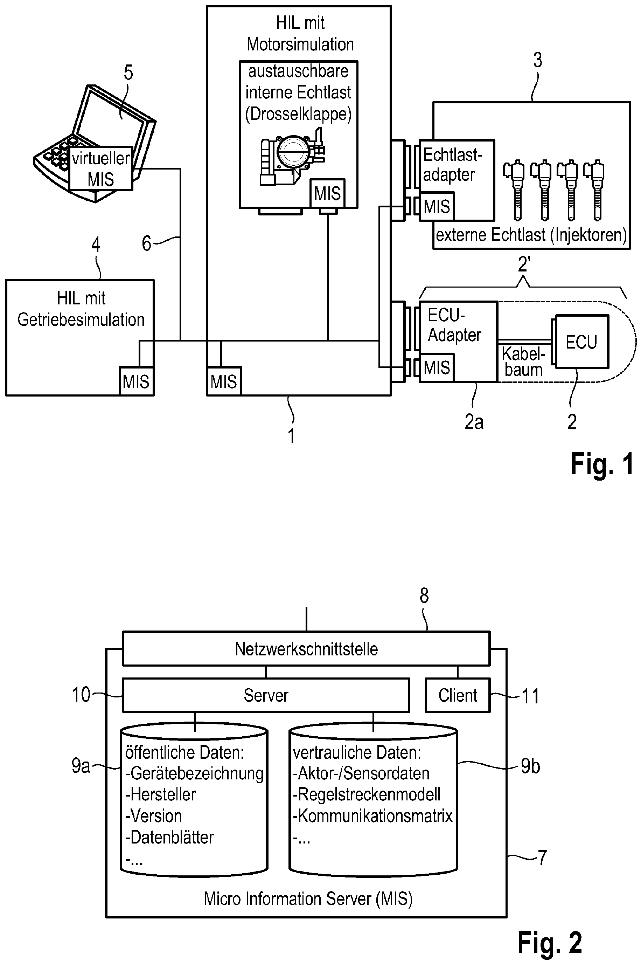

Die Figur 1 zeigt in einer insgesamten Darstellung in der Form eines Blockdiagramms ein Testsystem 1 zur Durchführung eines Tests eines Steuergerätes 2, bei welchem einem Steuergerät 2 mittels einer Simulationsarchitektur eine Umgebung simuliert wird, insbesondere eine solche Umgebung, die auch bei dem konkreten Einsatz des Steuergerätes 2 in einer späteren Vorrichtung, wie beispielsweise einem Kraftfahrzeug vorliegt.

Die Simulationsarchitektur kann bereits mehrere Hardwarekomponenten, z.B. einen hier nicht gezeigten Rechner des Testsystems 1 umfassen und zum Beispiel durch ein proprietäres System eines bestimmten Herstellers realisiert sein. Vorliegend wird ein System der Patentanmelderin dargestellt, bei welchem über ein Netzwerk 6 mehrere Hardwarekomponenten 2,3,4 miteinander kommunizieren und an das Testsystem 1 angeschlossen sind, auf dem der nicht gezeigte Rechner eine Testumgebung simuliert wird.

Hier können die Hardwarekomponenten 2,3,4 z.B. durch intelligente Knoten oder Router in das Netzwerk 6 eingebunden sein, insbesondere sofern sie nicht selbst geeignete Netzwerkschnittstellen aufweisen.

Es kann weiterhin über das gleiche erste Netzwerk 6 auch ein an das Testsystem angeschlossener Steuerrechner 5 vorgesehen ist, beispielsweise um das Testsystem zu parametrisieren beziehungsweise die benötigte Software oder ein Modell aufzuladen und zu starten oder aus sonstigen Gründen mit dem Testsystem zu kommunizieren.

Für das erfindungsgemäße Verfahren ist es hier vorgesehen, dass zumindest die simulationsindividuellen Komponenten 2,3,4 ggfs. auch der Rechner der Testumgebung bzw. die zusammengefasste proprietäre Hardware der Testumgebung 1 und auch der Steuerrechner 5 einen Server umfassen, der hier als MIS dargestellt ist, als Abkürzung für Micro-Information-Server.

Dieser Server ist in Software ausgebildet entweder auf der Hardware-Komponente 2,3,4 bzw. auch 1,5, unmittelbar selbst oder in einer separaten daran angeordneten Server-Hardware. Der jeweilige Server MIS kann über dasselbe Netzwerk 6 mit einem Client auf den Rechner des Testsystems 1 oder einem Client auf dem Steuerrechner 5 kommunizieren und hierdurch Zugang erhalten zu Konfigurationsdaten, die bei der Ausführung des Modell mit der jeweiligen Hardwarekomponente benötigt werden. Es kann so nach einem Übertragen der Konfigurationsdaten zum Steuerrechner 5 oder den Rechner des Testsystem 1 eine Anpassung des Modells erfolgen in Abhängigkeit der Konfigurationsdaten.

Bzgl. des Steuergerätes 2 ist dargestellt, dass dieses keinen eigenen Server aufweist, jedoch über ein Verbindungselement 2a mit dem Testsystem 1 verbunden ist, wobei das Verbindungelement einen Server MIS aufweist und hierdurch eine neue Einheit 2' mit Server MIS gebildet wird.

Die Figur 2 visualisiert eine Serverhardware 7, die separat zur Hardwarekomponenten an dieser angeordnet sein kann oder auch durch einen Teil der Hardwarekomponenten ausgebildet sein kann. Hier wird deutlich, dass diese Serverhardware 7 eine Netzwerkschnittstelle 8 umfasst, um z.B. mit demselben Netzwerk 6 zu kommunizieren, über welches auch die Kommunikation bei der Simulation abgewickelt wird oder mit einem anderen separaten Netzwerk.

Eine hier gezeigte Ausführung sieht vor, dass in der Server-Hardware 7 zwei zumindest logisch ggfs. auch physikalisch getrennte Speicherbereiche 9a, 9b vorgesehen sind, in denen öffentliche und nicht-öffentliche Konfigurationsdaten oder auch zusätzliche Daten vorgehalten werden können, zu denen eine in der Serverhardware 7 ablaufende Serversoftware 10 Zugang gewährt. Dieser Zugang erfolgt über die Netzwerkschnittstelle 8 durch einen Client, z.B. des Steuerrechners 5, des Testsystem-Rechners oder auch eines Clients 11, der in einer anderen Serverhardware einer anderen Hardware-Komponente realisiert ist. So können die einzelnen Hardware-Komponenten 7 über die Netzwerkschnittstelle 8 und die einzeln jeweils vorhandene Server- und Client-Funktion miteinander vernetzt werden und Ihre Daten auch untereinander austauschen. Z.B. kann einer der genannten Rechner nur mit einem Server 10 einer Hardware-Komponente kommunizieren, über diese Hardware-Komponente jedoch auch Zugang erhalten zu den (Konfigurations-) Daten anderer Hardware-Komponenten.

## Patentansprüche

1. Verfahren zur Durchführung einer Konfiguration eines Steuergeräte-Testsystems (1), wobei mit dem Testsystem (1) Steuergeräte (2) in einer vom Testsystem (1) mittels eines Modells simulierten Umgebung testbar sind und wobei das Testsystem (1) zumindest einen Rechner, insbesondere das Modell ausführenden Rechner, und Hardware-Komponenten (2,3,4) umfasst, die mittels wenigstens eines Netzwerks (6) miteinander verbunden sind, **dadurch gekennzeichnet, dass** mindestens eine Hardware-Komponente (2, 3, 4) mit einem eigenen Server versehen ist der durch Kommunikation über eine Client-Server Funktionalität Zugang gewährt zu in der jeweiligen Hardware-Komponente (2,3,4) gespeicherten Konfigurationsdaten und das Modell und/oder die Hardware-Komponente (2,3,4) in Abhängigkeit der zugänglich gemachten Konfigurationsdaten konfiguriert wird, wobei der Server (MIS) der Hardware-Komponente durch eine Software implementiert ist, die auf einer für die Funktion der Hardware-Komponente während eines Tests nicht benötigten Server-Hardware ausgeführt wird, welche zum Zweck der Bereitstellung des Servers (MIS) an der Hardware-Komponente angeordnet wird, und wobei die Konfigurationsdaten durch zumindest eine Art der folgenden Daten gebildet werden:
a. eine durch den Rechner des Testsystems (1) ausführbare Modellkomponente;
b. Parameter oder Kennlinien eines Modells;
c. eine die Hardware-Komponente beschreibende Information.

2. Verfahren nach Anspruch 1, **dadurch gekennzeichnet, dass** ein Auslesen der Konfigurationsdaten mittels des Rechners des Testsystems (1) oder mittels eines an das Testsystem (1) angeschlossenen Steuer-Rechners (5) erfolgt, insbesondere wobei bei einem Auslesen mittels eines an das Testsystem angeschlossenen Steuer-Rechners (5) dieser Steuerrechner (5) anhand aller von mehreren Hardware-Komponenten (2,3,4) erhaltener Konfigurationsdaten die Konfiguration des auf dem Rechner des Testsystems (1) laufenden Modells und/oder der Hardware-Komponenten (2,3,4) vornimmt.

3. Verfahren nach einem der vorherigen Ansprüche, **dadurch gekennzeichnet, dass** der Server (MIS) einer Hardware-Komponente implementiert ist durch
a. eine Software (10), die durch einen für die Funktion der Hardware-Komponente (2,3,4) während eines Tests verwendeten Prozessor ausgeführt wird, oder
b. eine Software (10), die auf einem für die Funktion der Hardware-Komponente (2,3,4) während eines Tests nicht benötigten Server-Hardware (7), insbesondere die einen Prozessor umfasst, ausgeführt wird, welche zum Zweck der Bereitstellung des Servers (MIS) an der Hardware-Komponente (2,3,4) angeordnet wird.

4. Verfahren nach Anspruch 3, **dadurch gekennzeichnet, dass** die Konfigurationsdaten über dasselbe Netzwerk (6) kommuniziert werden, mittels dem die Hardwarekomponente (2,3,4) während der Simulation mit dem das Modell ausführenden Rechner kommuniziert.

5. Verfahren nach Anspruch 3, **dadurch gekennzeichnet, dass** die Konfigurationsdaten über ein Netzwerk kommuniziert werden, welches von demjenigen Netzwerk (6) getrennt ist, mittels dem die Hardwarekomponente (2,3,4) während der Simulation mit dem das Modell ausführenden Rechner kommuniziert.

6. Verfahren nach einem der vorherigen Ansprüche, **dadurch gekennzeichnet, dass** eine den Server (MIS) einer zu testenden Hardwarekomponente (2,3,4) ausführende Server-Hardware (7) integriert wird in ein zur Verbindung einer Hardwarekomponente (2) mit dem Testsystem (1) vorgesehenen Verbindungselement (2a), insbesondere in einen Anschlußstecker eines Verbindungselementes (2a), insbesondere Kabelbaumes.

7. Verfahren nach einem der vorherigen Ansprüche, **dadurch gekennzeichnet, dass** ein Server (MIS) Zugang gewährt
a. zu zumindest einem Speicherplatz (9a) mit öffentlichen Daten und/oder
b. zu zumindest einem Speicherplatz (9b) mit nicht-öffentlichen Daten, nachdem der Server (MIS) eine Authentifizierung eines anfragenden Rechners (5) vorgenommen hat.

8. Verfahren nach einem der vorherigen Ansprüche, **dadurch gekennzeichnet, dass** in der separaten Serverhardware (7) mehrerer Hardware-Komponenten (2,3,4) oder direkt in mehreren Hardwarekomponenten (2,3,4) des Testsystems (1) jeweils ein Client (11), insbesondere ein als Software ausgebildeter Client (11) implementiert ist, wobei mittels des jeweiligen Clients (11) mehrere Server (MIS) verschiedener Hardware-Komponenten (2,3,4) miteinander vernetzt werden, die Konfigurationsdaten untereinander kommunizieren, insbesondere wobei ein beteiligter Rechner (5) durch Kommunikation mit einem der vernetzten Server (MIS) Zugang erhält zu den Konfigurationsdaten der mit diesem Server (MIS) vernetzten anderen Server (MIS).

9. Verfahren nach einem der vorherigen Ansprüche, **dadurch gekennzeichnet, dass** ein Server (MIS) eine Web-Server-Funktionalität umfasst, mittels der, insbesondere unter Verwendung des Steuer-Rechners (5), Änderungen an den durch den Server (MIS) zugänglich gemachten Daten vorgenommen werden können.

10. Verfahren nach einem der vorherigen Ansprüche, **dadurch gekennzeichnet, dass** ein Server (MIS) einer Hardware-Komponente (2,3,4) Zugang gewährt zu einer die Hardware-Komponente (2,3,4) identifizierenden Information, insbesondere zu einer Seriennummer, insbesondere zur Durchführung einer Inventarisierung der Hardware-Komponenten (2,3,4) des Testsystems (1).

## Claims

1. A method for performing a configuration of a control unit test system (1), wherein with the test system, (1) control devices (2) are testable in an environment simulated by the test system (1) by means of a model and wherein the test system (1) comprises at least one computer, in particular computer executing the model, and hardware components (2,3,4), which are connected to each other by means of at least one network (6), **characterized in that** at least one hardware component is provided (2, 3, 4) with its own server,
which, through communication via a client-server functionality,
is configured to grant access to configuration data stored in the respective hardware component (2,3,4) and the model and/or the hardware component (2,3,4) is configured as a function of the configuration data made accessible, wherein the server (MIS) of the hardware component is implemented by a software which is executed on a server hardware not required for the functioning of the hardware component during a test, the server hardware being disposed on the hardware component for the purpose of providing the server (MIS), and wherein the configuration data are formed by at least one type of the following data:
a.a model component executable by the computer of the test system (1);
b.parameters or characteristic curves of a model;
c.an information describing the hardware component.

2. The method according to claim 1, **characterized in that** a read-out of the configuration data is performed by means of the computer of the test system (1) or by means of a control computer (5) connected to the test system (1), in particular wherein with a read-out by means of a control computer (5) connected to the test system, this control computer (5) carries out the configuration of the model running on the computer of the test system (1) and/or of the hardware components (2, 3, 4) on the basis of all configuration data obtained from a plurality of hardware components (2, 3, 4).

3. The method according to one of the preceding claims, **characterized in that** the server (MIS) of a hardware component is implemented by
a. a software (10) which is executed by a processor used for the functioning of the hardware component (2,3,4) during a test, or
b. a software (10) which is executed on a server hardware (7) not required for the functioning of the hardware component (2, 3, 4) during a test, in particular comprising a processor, which server hardware is disposed for the purpose of providing the server (MIS) to the hardware component (2,3,4).

4. The method according to claim 3, **characterized in that** the configuration data are communicated via the same network (6), by means of which the hardware component (2, 3, 4) communicates with the computer executing the model during the simulation.

5. The method according to claim 3, **characterized in that** the configuration data are communicated via a network which is separate from the network (6) by means of which the hardware component (2, 3, 4) communicates with the computer executing the model during the simulation.

6. The method according to one of the preceding claims, **characterized in that** a server hardware (7) executing the server (MIS) of a hardware component (2, 3, 4) to be tested is integrated into a connecting element (2a) provided for connecting a hardware component (2) to the test system (1), in particular in a connector plug of a connecting element (2a), in particular cable harness.

7. The method according to one of the preceding claims, **characterized in that** a server (MIS) grants access
a. to at least one memory space (9a) having public data and/or
b. to at least one memory space (9b) having non-public data after the server (MIS) has performed authentication of a requesting computer (5).

8. The method according to one of the preceding claims, **characterized in that** in each case, a client (11), in particular a client (11) configured as a software, is implemented in the separate server hardware (7) of a plurality of hardware components (2, 3, 4) or directly in a plurality of hardware components (2, 3, 4) of the test system (1), wherein by means of the respective client (11), several servers (MIS) of different hardware components (2, 3, 4) are networked with one another, which hardware components communicate configuration data with each other, in particular wherein a participating computer (5), by comminication with one of the networked servers (MIS), receives access to the configuration data of other servers (MIS) networked with this server (MIS).

9. The method according to one of the preceding claims, **characterized in that** a server (MIS) comprises a web server functionality, by means of which, in particular using the control computer (5), changes to the data made available by the server (MIS) can be made.

10. The method according to one of the preceding claims, **characterized in that** a server (MIS) of a hardware component (2, 3, 4) grants access to an information identifying the hardware component (2, 3, 4), in particular to a serial number, in particular for performing an inventory of the hardware components (2, 3, 4) of the test system (1).

## Revendications

1. Procédé pour réaliser une configuration d'un système de test (1) d'appareils de commande, sachant que des appareils de commande (2) peuvent être testés avec le système de test (1) dans un environnement simulé par le système de test (1) au moyen d'un modèle, et sachant que le système de test (1) comporte au moins un ordinateur, en particulier, un ordinateur qui exécute le modèle, et des composants matériels (2, 3, 4) qui sont connectés les uns avec les autres au moyen d'au moins un réseau (6), **caractérisé en ce qu'**un composant matériel (2, 3, 4) au moins est pourvu d'un serveur propre qui, par communication via une fonctionnalité client-serveur, donne accès aux données de configuration stockées dans le composant matériel (2, 3, 4) respectif et le modèle et/ou le composant matériel (2, 3, 4) est/sont configuré(s) en fonction des données de configuration rendues accessibles, sachant que le serveur (MIS) du composant matériel est mis en oeuvre par un logiciel qui est exécuté sur un matériel serveur qui n'est pas nécessaire pour le fonctionnent du composant matériel pendant un test, lequel est agencé au composant matériel pour fournir le serveur (MIS), et sachant que les données de configuration sont formées par au moins un type des données suivantes :
a. un composant de modèle exécutable par l'ordinateur du système de test (1) ;
b. des paramètres ou des courbes caractéristiques d'un modèle ;
c. une information décrivant le composant matériel.

2. Procédé selon la revendication 1, **caractérisé en ce que** les données de configuration sont lues au moyen de l'ordinateur du système de test (1) ou au moyen d'un ordinateur de commande (5) relié au système de test (1), sachant en particulier que, dans le cas d'une lecture au moyen d'un ordinateur de commande (5) relié au système de test, cet ordinateur de commande (5) effectue la configuration du modèle courant sur l'ordinateur du système de test (1) et/ou des composants matériels (2, 3, 4) sur la base de toutes les données de configuration obtenues de plusieurs composants matériels (2, 3, 4).

3. Procédé selon l'une des revendications précédentes, **caractérisé en ce que** le serveur (MIS) d'un composant matériel est mis en oeuvre par
a. un logiciel (10), qui est exécuté par un processeur utilisé pour le fonctionnent du composant matériel (2, 3, 4) pendant un test, ou
b. un logiciel (10), qui est exécuté sur un matériel serveur (7), comprenant en particulier un processeur, qui n'est pas nécessaire pour le fonctionnement du composant matériel (2, 3, 4) pendant un test, lequel est disposé au composant matériel (2, 3, 4) afin de fournir le serveur (MIS).

4. Procédé selon la revendication 3, **caractérisé en ce que** les données de configuration sont communiquées via le même réseau (6) que celui au moyen duquel le composant matériel (2, 3, 4) communique avec l'ordinateur qui exécute le modèle pendant la simulation.

5. Procédé selon la revendication 3, **caractérisé en ce que** les données de configuration sont communiquées via un réseau qui est séparé du réseau (6) à l'aide duquel le composant matériel (2, 3, 4) communique avec l'ordinateur qui exécute le modèle pendant la simulation.

6. Procédé selon l'une des revendications précédentes, **caractérisé en ce qu'**un matériel serveur (7) exécutant le serveur (MIS) d'un composant matériel (2, 3, 4) devant être testé est intégré dans un élément de connexion (2a) prévu pour connecter un composant matériel (2) au système de test (1), en particulier, dans une fiche de connexion d'un élément de connexion (2a), en particulier, un faisceau de câbles.

7. Procédé selon l'une des revendications précédentes, **caractérisé en ce qu'**un serveur (MIS) accorde l'accès
a. à au moins un emplacement de mémoire (9a) avec des données publiques et/ou
b. à au moins un emplacement de mémoire (9b) avec des données non publiques, après que le serveur (MIS) ait effectué une authentification d'un ordinateur demandeur (5).

8. Procédé selon l'une des revendications précédentes, **caractérisé en ce qu'un** client (11), en particulier un client (11) conçu en tant que logiciel, est mis en oeuvre dans le matériel serveur (7) séparé de plusieurs composants matériels ou directement dans plusieurs composants matériels (2, 3, 4) du système de test (1), sachant que plusieurs serveurs (MIS) de composants matériels (2, 3, 4) différents sont mis en réseau les uns avec les autres au moyen du client (11) respectif, qui communiquent des données de configuration entre elles, sachant en particulier qu'un ordinateur impliqué (5), par communication avec l'un des serveurs (MIS) mis en réseau, obtient l'accès aux données de configuration des autres serveurs (MIS) en réseau avec ce serveur (MIS).

9. Procédé selon l'une des revendications précédentes, **caractérisé en ce qu'**un serveur (MIS) comprend une fonctionnalité de serveur web, à l'aide de laquelle des modifications peuvent être effectuées sur les données rendues accessibles par le serveur (MIS), en particulier, par utilisation de l'ordinateur de commande (5).

10. Procédé selon l'une des revendications précédentes, **caractérisée en ce qu'**un serveur (MIS) accorde à un composant matériel (2, 3, 4) l'accès à une information identifiant le composant matériel (2, 3, 4), en particulier, à un numéro de série, en particulier, en vue de l'exécution d'un inventaire des composants matériels (2, 3, 4) du système de test (1).
